# EUROPEAN PATENT APPLICATION

(11) **EP 0 765 042 A2**
(43) Date of publication of application: **26.03.1997**
(21) Application number: 96306562.8
(22) Date of filing: 10.09.1996
(51) Int. Cl.: H04B 1/04, H04B 15/00

(54) **A time-division radio that induces reduced baseband interference**

(30) Priority: 19.09.1995 US 530687
(71) Applicant: AT&T Corp., New York, NY 10013-2412 (US)
(72) Inventor: Greenstein, Lawrence Joel, Edison, New Jersey 08837 (US); Vannucci, Giovanni, Red Bank, New Jersey 07701 (US); Shah, Nitin Jayant, Scotch Plains, New Jersey 07076 (US)
(74) Representative: Buckley, Christopher Simon Thirsk

(57) **Abstract**

A method and apparatus is disclosed for reducing the electromagnetic interference that results from TDMA and TDD radios, i.e., radios which radiate an RF signal with a time-varying power envelope. A radio comprising an embodiment of the present invention radiates, in transmit mode, an information-bearing signal at an average RF power in a transmit-mode channel but radiates, in idle mode, a signal at the same average RF power but in an idle-mode channel. In essence, the radio transmits during its idle mode at the same average power level as during transmit mode but in a different frequency channel, one that is dedicated to that purpose.

## Description

### Field of the Invention

The present invention relates to radios in general and, more particularly, to time division radios and methods that induce reduced baseband interference.

### Background of the Invention

Radios that employ time-division technology are suspected of inducing baseband interference in some electrical devices. Time-division multiple access ("TDMA"), time-division duplexing ("TDD"), and hybrid time-division multiple access/time-division duplexing ("TDMA/TDD") are typical of such time-division systems. As used in this specification, "time division technology" does not include time-division multiplexing ("TDM").

There are several national and international standards that TDMA and they include: Global Systems for Mobile Communication ("GSM"), the Telecommunications Industry Association Interim Standard No. 54 ("IS-54"), and Japanese Digital Cellular ("JDC"). One standard that prescribes TDD is "CT-2." Two standards that prescribe TDMA/TDD include Personal Handy Phone and Digital European Cordless Telephone.

IS-54 prescribes the operation of a typical TDMA system. According to IS-54, three radios, each in a different wireless terminal, time-share a frequency-delimited channel for transmitting signals to a base station. For the purposes of this specification, that channel is called the "transmit-mode channel."

Each TDMA radio cycles between "transmit mode" and "idle mode." During a transmit mode, a TDMA radio modulates a carrier with an information-bearing signal and transmits the modulated carrier to a base station in the transmit-mode channel. During an idle mode, a TDMA radio does not transmit anything so as to (1) prevent an idle radio from interfering with the appropriately radiating radio (i.e., to preclude a cacophony in the transmit-mode channel) and (2) conserve battery power.

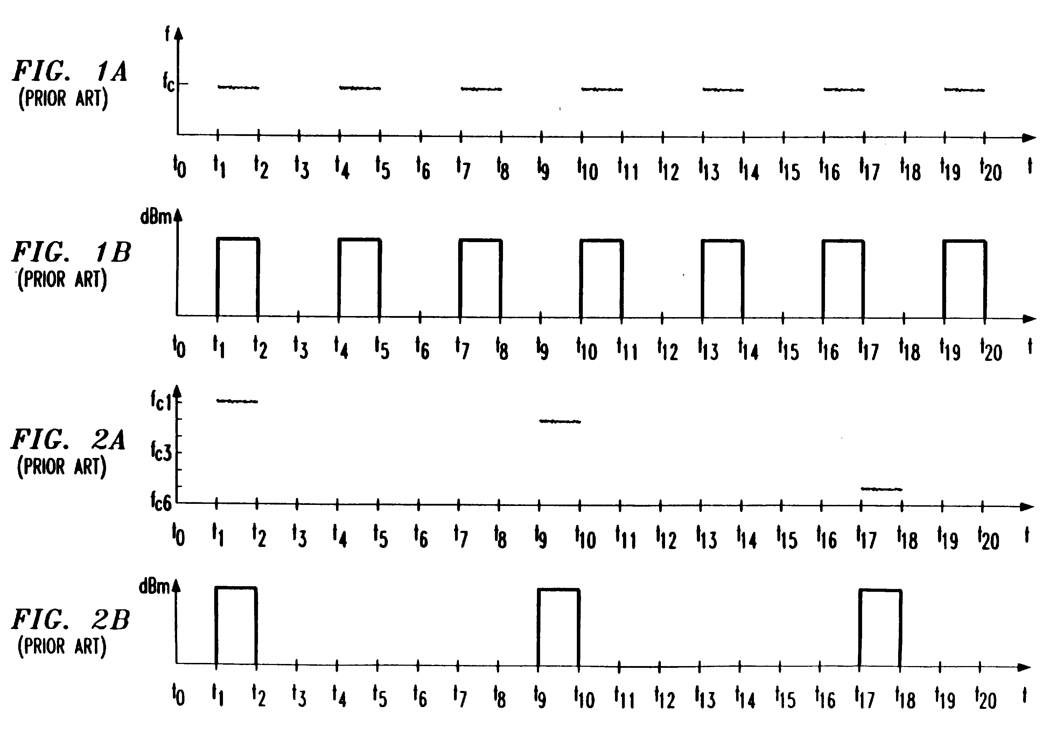

Figs. 1a and 1b illustrate the frequency and average RF power envelope, respectively, (as a function of time) of the first of three IS-54 compliant radios, in different wireless terminals, that time-share a single transmit-mode channel, designated *f*_{*c*}*.* The transmit modes of the first radio occur during the time intervals *t*_{*3n+1*} to *t*_{*3n+2*} (where *n* is an integer), which coincide with the idle modes of the second and third radios. The idle modes of the first radio occur during the time intervals *t*_{*3n+2*} to *t*_{*3n+4*}. Although not shown in Figs. 1a and 1b, the transmit modes of the second radio occur during the time intervals *t*_{*3n*} to *t*_{*3n+1*}, which coincide with the idle modes of the first radio and third radio. Similarly, the transmit modes of the third radio occur during the time intervals *t*_{*3n+2*} to *t*_{*3n+3*}, which coincide with the idle modes of the first radio and second radio.

The rate at which a time-division radio cycles between transmit mode and idle mode is referred to as the "frame rate." This cycling causes the average RF power envelope radiated by the radio to vary with time. Specifically, as illustrated in Fig. 1b, an IS-54 compliant radio generates an average RF power envelope with a fundamental frequency component that is equal to the frame rate.

Figs. 2a and 2b illustrate the frequency and average RF power envelope, respectively, (as a function of time) for a typical GSM compliant radio, as contained in a typical wireless terminal in the prior art.

According to the GSM standard, a plurality of time-division radios, in different wireless terminals, time-share and frequency-hop among a plurality of transmit-mode channels, as illustrated in Fig. 2a. Therefore, it is likely that a single GSM compliant radio will transmit in several frequency-delimited transmit-mode channels during the course of a single call. Like other time-division radios in the prior art, a typical GSM compliant radio ceases to radiate during idle mode. Thus, a GSM compliant radio also generates a time varying average RF power envelope that has a fundamental frequency component that is equal to the frame rate.

The operation of a TDD system is similar, although not identical, to a TDMA system. In a TDD system, two radios time-share a frequency-delimited channel for communication with the other. Each TDD radio periodically cycles between transmit mode and idle mode, and like the TDMA radio, during transmit mode modulates a carrier with an information-bearing signal and transmits the modulated carrier in the transmit-mode channel. For the same reasons as a TDMA radio, during idle mode a TDD radio does not transmit anything. And also like a TDMA radio, a TDD radio generates an average RF power envelope with a fundamental frequency component that is equal to the frame rate.

The operation of a TDMA/TDD radio is a hybrid of both TDMA and TDD systems and, too, generates an average RF power envelope with a fundamental frequency component that is equal to the frame rate.

### Summary of the Invention

Embodiments of the present invention can induce less baseband interference in sensitive electronics than TDMA radios in the prior art. An illustrative embodiment of the present invention comprises a TDMA radio that transmits continuously during both transmit mode and idle mode. During transmit mode, the TDMA radio transmits a signal in one or more transmit-mode channels, and during idle mode, the TDMA radio transmits a signal, at the same average RF power as during the transmit mode, but in one or more idle-mode channels that are designated for that purpose. By transmitting the signal in the idle-mode channel, the TDMA radio abates the energy in a fundamental frequency and low frequency harmonics of the average RF power envelope of the radio and reduces the risk of interfering with sensative electronics.

### Brief Description of the Drawing

For a more complete understanding of the present invention, reference is now made to the accompanying drawings in which like numbers indicate like features and wherein:
Figs. 1a and 1b are graphs that illustrate the frequency and average RF power envelope, respectively, (as a function of time) of an IS-54 compliant TDMA radio;
Figs. 2a and 2b are graphs that illustrate the frequency and average RF power envelope, respectively, (as a function of time) of a GSM compliant radio;
Figs. 3a and 3b are graphs that illustrate the frequency and average RF power envelope, respectively, (as a function of time) for an embodiment of the present invention that is IS-54 compliant;
Figs. 4a and 4b are graphs that illustrate the frequency and average RF power envelope, respectively, (as a function of time) for an embodiment of the present invention that is GSM compliant;
Fig. 5 is a block diagram of an illustrative embodiment of the present invention;
Fig. 6 is a block diagram of a carrier frequency generator for use in the radio of Fig. 5, according to the teachings of the present invention;
Fig. 7 is a block diagram of another carrier frequency generator for use in the radio of Fig. 5, according to the teachings of the present invention; and
Fig. 8 is a flow chart of the operation of a typical embodiment of the present invention.

### Detailed Description

An RF signal with a time-varying average power envelope can induce baseband interference in a device that is characterized by a nonlinear response to radio waves. The operative mechanism could be, but is not necessarily, a second-order non-linearity in the device, which produces an effect similar to that of a square-law envelope detector. Figures 1a, 1b, 2a and 2b show that IS-54 and GSM compliant radios each produce an average RF power envelope with a fundamental frequency component that is in the audio-band. Therefore, these radios might be responsible for interference with some electronics devices, such as hearing aids.

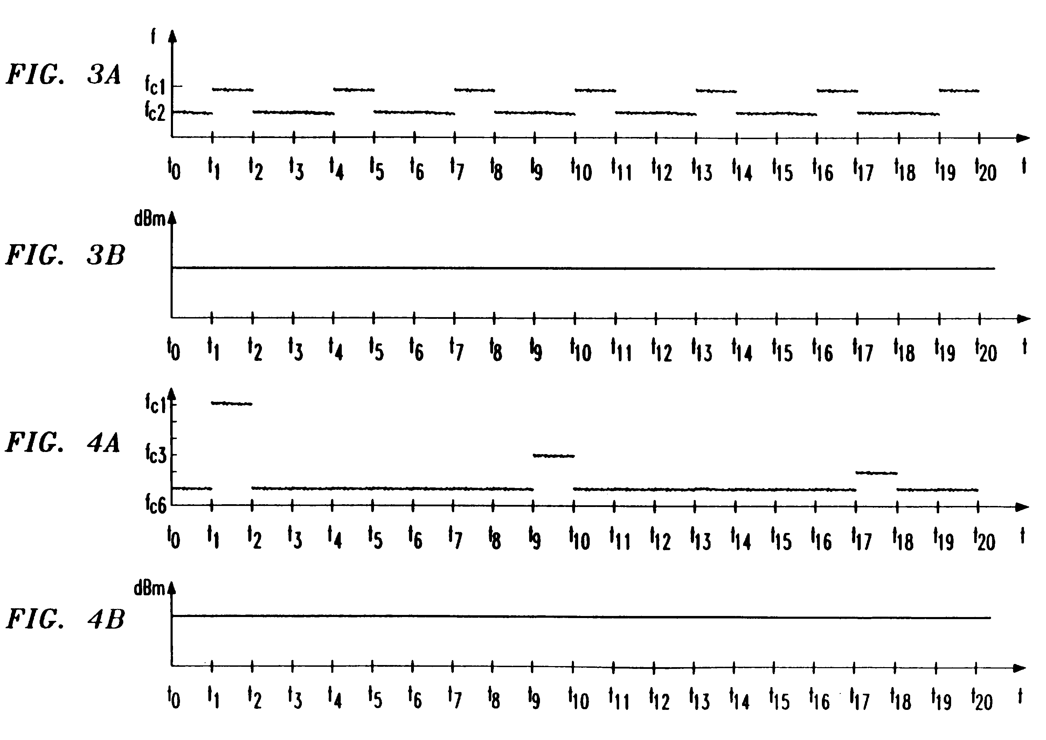

Figs. 3a and 3b illustrate the frequency and average RF power envelope, respectively, (as a function of time) for an illustrative embodiment of the present invention that is IS-54 compliant. In this embodiment, the TDMA radio transmits an information-bearing signal during transmit mode (e.g., during the time interval from *t*_{*3n+1*} to *t*_{*3n+2*}, where *n* is an integer), with a carrier frequency,*f*_{*c1*}, in the transmit-mode channel. During idle mode (e.g., during the time interval *t*_{*3n+2*} to *t*_{*3n+4*}), the TDMA radio continues to transmit, but with a different carrier frequency,*f*_{*c2*}, in a different frequency-delimited channel.

For the purposes of this specification, the channel containing carrier frequency *f*_{*c2*} is referred to as the "idle-mode channel." It is inconsequential whether there is any information content to the signal transmitted in the idle-mode channel. For example, the TDMA radio can transmit in the idle-mode channel the information-bearing signal that was transmitted during the previous transmit mode. Alternatively, the TDMA radio could transmit an unmodulated carrier. As shown in Fig. 3b, the average RF power envelope for this embodiment does not exhibit the periodicity of a TDMA radio in the prior art, and, therefore, should not produce an average RF power envelope with a fundamental frequency component with significant energy.

A plurality of TDMA radios can radiate into the idle-mode channel at the same time, which reduces the amount of spectrum that needs to be assigned to needed to carry idle mode transmissions. For example, all a wireless service provider need do is assign one channel across the entire system to function as the idle-mode channel. Thereafter, the wireless service provider can program or remotely indicate to the TDMA wireless terminals in its system into which channel they should broadcast during their respective idle modes. Advantageously, a TDMA radio that embodies the present invention does not require any modification to the air interface of the current TDMA standards.

Figs. 4a and 4b similarly depict the frequency and average RF power envelope for a GSM compliant radio comprising another embodiment of the present invention. Although a GSM compliant radio frequency hops, in contrast to an IS-54 compliant radio, it will be clear from the present disclosure to those skilled in the art how to make and use a GSM compliant radio that embodies the present invention.

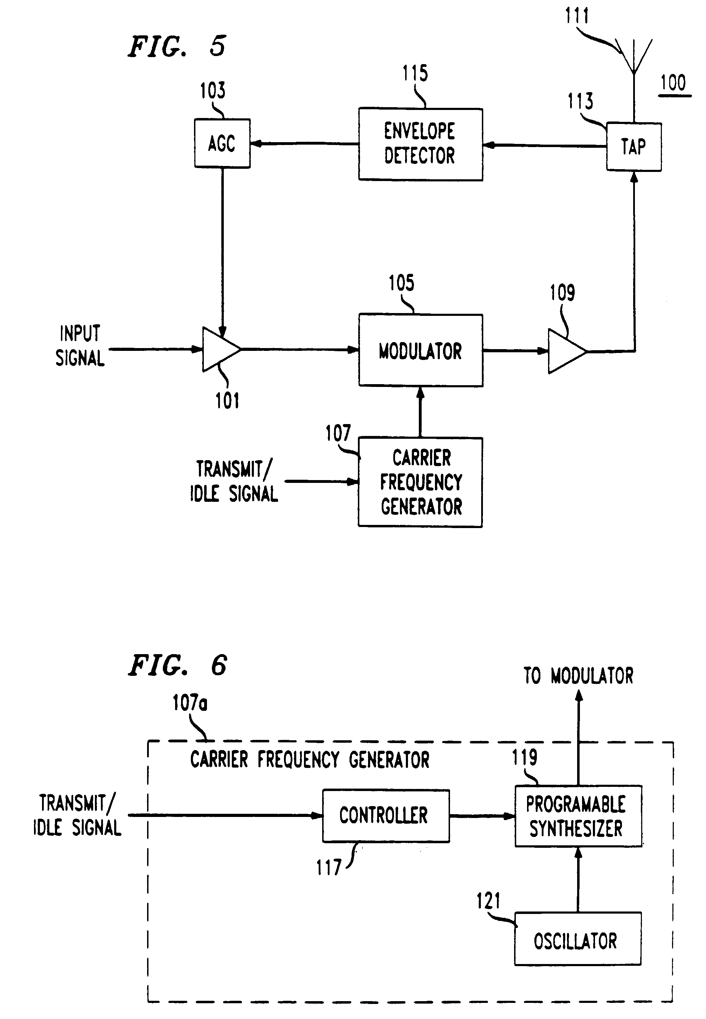

Fig. 5 depicts a block diagram of an illustrative embodiment of the present invention as presented in the context of a TDMA communications system. As described above, TDMA radio 100 shares a frequency channel, the "transmit-mode channel," with two or more other radios (not shown). Each radio has (1) a transmit mode, when an information-bearing signal is radiated in the transmit-mode channel, and (2) an idle mode, when nothing is radiated in the transmit-mode channei, but something is radiated in the idle-mode channel. By maintaining a constant average RF power level during both the transmit and idle modes, the effects of baseband interference can be greatly diminished.

An information-bearing signal that is to be transmitted to a recipient (e.g., voice, data, etc.) is advantageously fed into amplifier 101. The gain of amplifier 101 is advantageously controlled by automatic gain control 103. From amplifier 101, the information-bearing signal passes to modulator 105 where it modulates a carrier received from carrier frequency generator 107. Carrier frequency generator 107 generates a carrier based on a transmit/idle signal. It will be clear to those skilled in the art how to make and use amplifier 101, automatic gain control 103, and modulator 105.

The modulated signal output from modulator 105 is fed into amplifier 109 and to antenna 111. Tap 113 samples the signal fed to antenna 111 and feeds the samples to envelope detector 115. Envelope detector 115 feeds a signal to automatic gain control 103 that is representative of the average RF power of the radiated signal. It will be clear to those skilled in the art how to make and use tap 113 and envelope detector 115. It should be remembered that the purpose of amplifier 101, tap 113, envelope detector 115 and automatic gain control 103 is to assure that the illustrative embodiment always radiates at substantially close to the same average RF power whether the embodiment is in transmit mode or idle mode.

Fig. 6 depicts a block diagram of an embodiment of carrier frequency generator 107a for use with TDMA radio 100 of Fig. 5. Controller 117 receives a signal that indicates whether TDMA radio 100 is in transmit or idle mode. When TDMA radio 100 is in transmit mode, controller 117 directs programmable synthesizer 119 to synthesize a carrier in the transmit-mode channel assigned to TDMA radio 100. When, however, TDMA radio 100 is in idle mode, controller 117 directs programmable synthesizer 119 to synthesize a carrier with a frequency corresponding to the idle-mode channel. Oscillator 121 provides a reference signal to programmable synthesizer 119. It will be clear to those skilled in the art how to make and use controller 117 and oscillator 121.

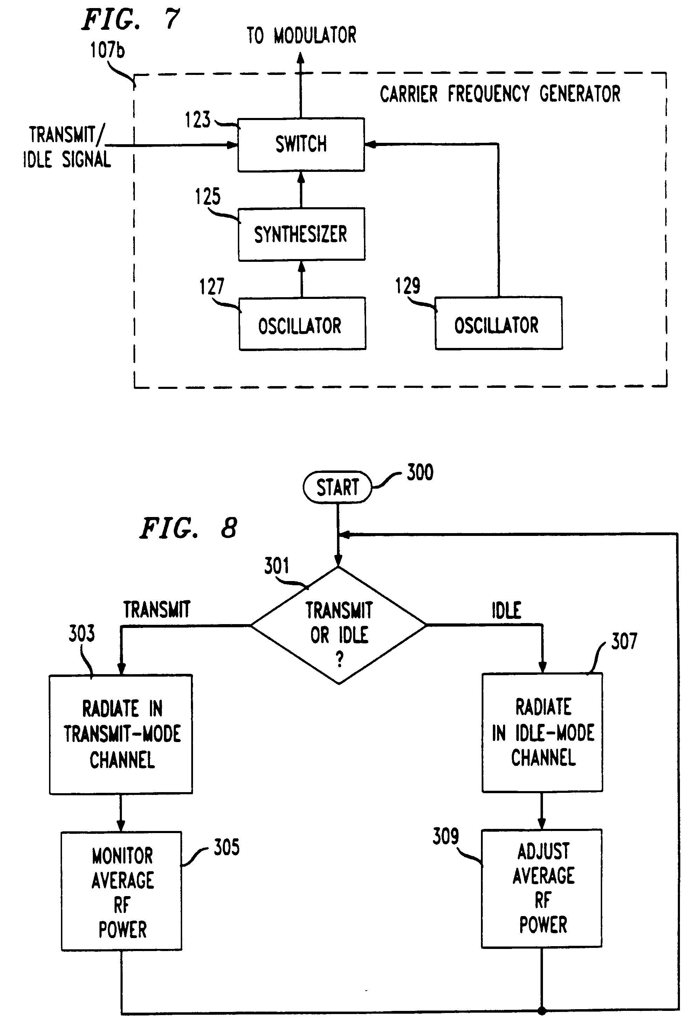

Fig. 7 depicts a block diagram of another embodiment of a carrier frequency generator 107b for use with TDMA radio 100. Switch 123 receives three signals: (1) a control signal that indicates whether TDMA radio 100 is in transmit mode or idle mode, (2) the synthesized carrier in the transmit-mode channel assigned to TDMA radio 100 (from synthesizer 125 and oscillator 127), and (3) a carrier for the idle-mode channel from oscillator 129. When TDMA radio 100 is in transmit mode, switch 123 directs the carrier from programmable synthesizer 125 to modulator 105. When TDMA radio 100 is in idle mode, switch 123 directs the carrier from oscillator 129 to modulator 105. The illustrative embodiment in Fig. 7 is advantageous in that synthesizer 125 need not be programmable and oscillator 129 can be relatively less precise, and hence relatively less expensive, than oscillator 127. It will be clear to those skilled in the art how to make and use this embodiment of carrier frequency generator 107b.

The operation of the illustrative embodiments in Figs. 5 through 7 can be depicted by the flowchart in Fig. 8. The method begins at block 300. At block 301, a decision is made whether the TDMA radio is in transmit or idle mode. When the radio is in transmit mode, the method proceeds to block 303 and radiates an information-bearing signal in the transmit-mode channel, which is time-shared with other TDMA radios. At block 305, the average RF power of the transmitted information-bearing signal transmitted is monitored. Control then returns to block 301.

At block 301, when the TDMA radio is in idle mode, the method proceeds to block 307. At block 307, the TDMA radio transmits a signal in the idle-mode channel. At block 309, the method adjusts the average RF power of the signal radiated in the idle-mode channel to be substantially close to the average RF power of the radiated information-bearing signal.

Although embodiments of the present invention have been described in detail, it is understood that various changes, alterations and substitutions can be made hereto without departing from the spirit and scope of the present invention as defined by the appended claims. For example, embodiments of the present invention can be used with TDMA systems wherein more than three users share the same transmit channel. Additionally, the teachings of the present invention are applicable to a TDMA system that uses frequency hopping (e.g., a GSM compliant wireless terminal). Furthermore, it will be clear to those skilled in the art how embodiments of the present invention can be made and used that use more than one transmit-mode channel and/or more than one idle-mode channel. And furthermore, the described embodiments may be incorporated into a wireless terminal with one or more other radios, which may be known as "dual-mode" or "tri-mode" wireless terminals.

## Claims

1. A time division multiple access radio comprising:
a carrier frequency generator; and
a modulator responsive to said carrier frequency generator that modulates a first carrier signal with a first signal during a transmit mode and that modulates a second carrier signal with a second signal during an idle mode, said second carrier signal being different than said first carrier signal.

2. The radio of claim 1, wherein said second signal is the same as said first signal.

3. The radio of claim 1, wherein said carrier frequency generator comprises:
a first oscillator;
a synthesizer responsive to said oscillator that produces the first carrier signal;
a second oscillator that produces the second carrier signal;
a switch that receives said first and second carrier signals, that directs said first carrier signal to said modulator when said radio is in said transmit mode, and that directs said second carrier signal to said modulator when said radio is in said idle mode.

4. The radio of claim 3, wherein said radio radiates at a substantially constant average RF power.

5. The radio of claim 3, and further including a feedback circuit coupled to control the radio to maintain a substantially constant average RF power.

6. The radio of claim 1, wherein said carrier frequency generator comprises:
an oscillator that provides a reference signal;
a programmable synthesizer responsive to said oscillator that generates first and second carrier signals for said modulator; and
a controller coupled to said programmable synthesizer that directs said programmable synthesizer to produce said second carrier signal when said radio is in said idle mode.

7. The radio of claim 6, wherein said radio radiates at a substantially constant average RF power.

8. The radio of claim 6, and further including a feedback circuit coupled to control the radio to maintain a substantially constant average RF power.
